Europäisches Patentamt

European Patent Office

Office européen des brevets

(19)

(11) Publication number: **0 059 264**
A1

## (12) EUROPEAN PATENT APPLICATION

(21) Application number: **81110369.6**

(22) Date of filing: **11.12.81**

(51) Int. Cl.³: **H 01 L 21/76**
H 01 L 21/308, H 01 L 29/06

(30) Priority: **02.03.81 US 239749**

(43) Date of publication of application:
**08.09.82 Bulletin 82/36**

(84) Designated Contracting States:
**DE FR GB**

(71) Applicant: **Rockwell International Corporation**
**3370 Miraloma Avenue**
**Anaheim California 92803(US)**

(72) Inventor: **Soclof, Sidney Isaac**
**6419 N. Lemon**
**San Gabriel California 91775(US)**

(74) Representative: **Wagner, Karl H., Dipl.-Ing.**
**P.O. Box 22 02 46 Gewuerzmuehlstrasse 5**
**D-8000 München 22(DE)**

(54) NPN Type lateral transistor with minimal substrate operation interference and method for producing same.

(57) The invention provides a unique sub-micron dimensioned NPN type transistor and method of making the same wherein hundreds of such transistors may be fabricated on a single chip with each transistor comprising an active region surrounded by field oxide completely isolating it from the substrate and its effects on operation. Slots made in the substrate permit angle evaporation of etch-resist to protect the active region while it is disconnected from the substrate by etching therebeneath via the slots. Substrate oxidation supports the active regions while orthogonal slots are provided permitting access to opposed sides of the active regions for doping P+ which is driven in from one side only while N+ is introduced and driven in from both sides, thereby providing an N+ P+P, N+ emitter, base, collector transistor active region to which electrical connections are applied using conventional techniques, providing almost complete reduction of the parasitic capacitances and resistances because of the total oxide isolation of the active regions from the substrate.

FIG.6

EP 0 059 264 A1

## NPN TYPE LATERAL TRANSISTOR
## WITH MINIMAL SUBSTRATE OPERATION INTERFERENCE
## AND METHOD FOR PRODUCING SAME

Field of the Invention

This invention is a novel structure and method for forming a sub-micron NPN type lateral dielectrically isolated transistor utilizing VLSI chip processing steps to fabricate hundreds of such devices simultaneously.

Background of the Invention

Techniques extracted from the prior art come from the field of sub-micron fabrication technology wherein the dimensional resolution is now comparable to or even smaller than the thicknesses of the thermally grown silicon oxide layers on silicon. Also the dimensions are now comparable to or even smaller than the base widths used for double diffused transistors, i.e. 0.4-1.0 micrometers. From these techniques, the novel structure and method for the NPN lateral transistor with greatly reduced parasitic capacitance and resistances is achieved.

Summary of the Invention

The invention is a novel lateral NPN type transistor formed on a substrate by orthogonal slots which define each active region and permit doping of the active regions via opposed slots while supported by oxidation achieved through underlying etching of each active region in a semi-array of regions supported at spaced apart positions and totally isolated from the substrate by substrate oxidation. Electrical connections are conventionally made to the N+ emitter, P+P base and N+ collector.

Brief Description of the Drawings

FIG. 1 is a view in section through a P type substrate with photoresist applied through a slotted mask;

FIG. 2 shows the structure of FIG. 1 with slots formed in the substrate where not protected by the resist;

FIG. 3 is a perspective view of the substrate showing the first set of longitudinal slots;

FIG. 4 is a view in section showing the application of an angle evaporation etch resist layer partially protecting the edges of the slots;

FIG. 5 is a view in section with the etch resist layer in place and showing the effects of the etch having been applied via the slots to undercut the longitudinal regions which will become active regions of the transistors being formed;

FIG. 6 shows a structure of FIG. 5 after the etch resist has. been removed and following oxidation of the substrate to fill in the voids created by the etch;

FIG. 7 is a view in plan of the structure of FIG. 6 showing the orthogonal set of slots relative to the original set of slots;

FIG. 8 is a view in section taken across the orthogonal set of slots showing the boron ion implant step to produce the P+ doping shown;

FIG. 9 shows the structure of FIG. 8 taken after boron drive-in and the application of phosphorus deposit or implant;

FIG. 10 shows the structure of FIG. 9 following phosphorus drive-in from both sides to produce the N+ regions and following oxidation of the substrate to fill the slots and protect the top;

FIG. 11 is a top plan view of the completed structure showing in dashed outline the electrode connections for the emitter, base and collector for a single active region of a single transistor;

FIG. 12 is a view in perspective of the transistor active region, per se.

Detailed Description of a Preferred Embodiment

In the device produced in accordance with the present invention, the effects of the substrate are minimized relative to the operation of the device. It should be realized that the active region may be completely contained with the surface of area of 3d x 5d or $15d^2$ wherein d is only 0.4 micrometers. The isolated region is completely separated from the substrate by oxidation and the parasitic capacitances and resistances are almost completely reduced to a minimum value attainable because the transistor is reduced essentially to just its electronically active region whereas in the conventional (vertical) transistor, the electrically active region is only a very small fraction of the total transistor area. The dielectric isolation between transistors offered by the same substrate oxidation has advantages with respect to high frequency performance, high voltage integrated circuits, radiation resistance, circuit flexibility, i.e. the process can provide NPN, PNP, JFET, MOSFET's etc. on the same integrated circuit chip.

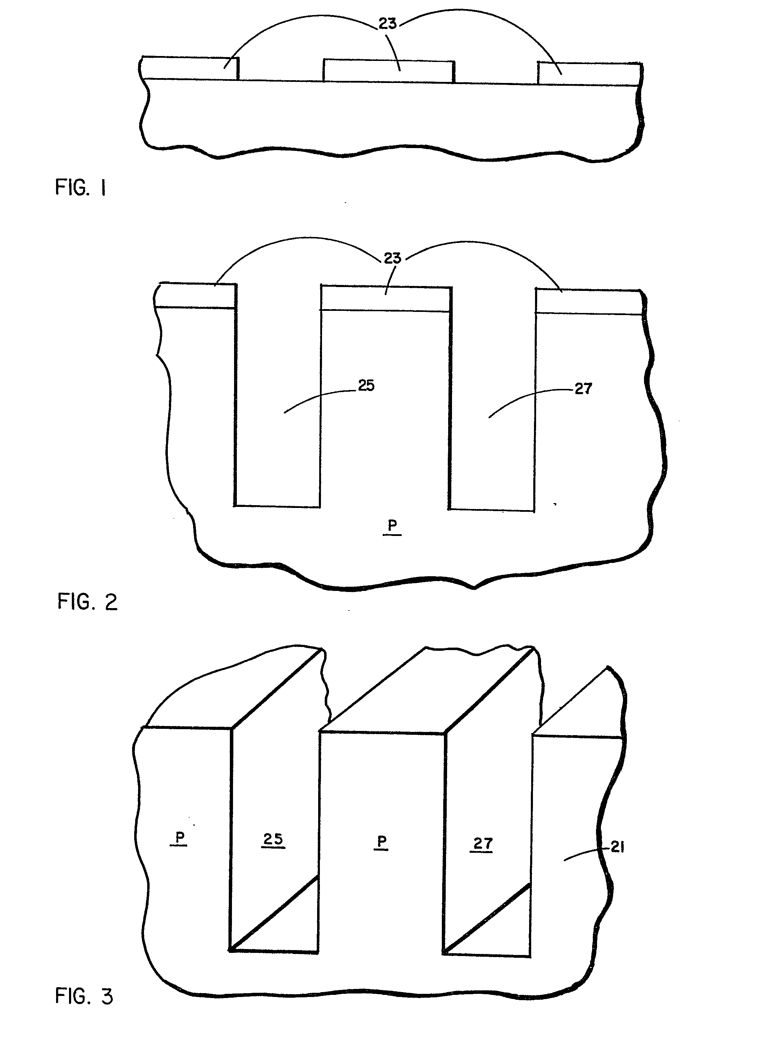

In FIG. 1 there is shown a silicon substrate of the P type, having patterned photoresist applied to an upper surface thereof. The pattern may simply comprise longitudinal slots for rendering the photoresist 23 alternately soluble and it may be seen that the soluble photoresist has been removed to provide exposure of the substrate 21 so that the slots 25 and 27 may be milled therein or formed by O.D.E. etching process. These slots 25 and 27 penetrate the upper surface of the silicon substrate 21 sufficiently deeply that they extend beneath the depth of the region which will ultimately become the active regions for the various transistors.

In FIG. 3, the photoresist layer 23 has been removed and the structure is shown in perspective thereby showing the slots 25 and 27 extending inwardly of the upper surface of silicon substrate 21.

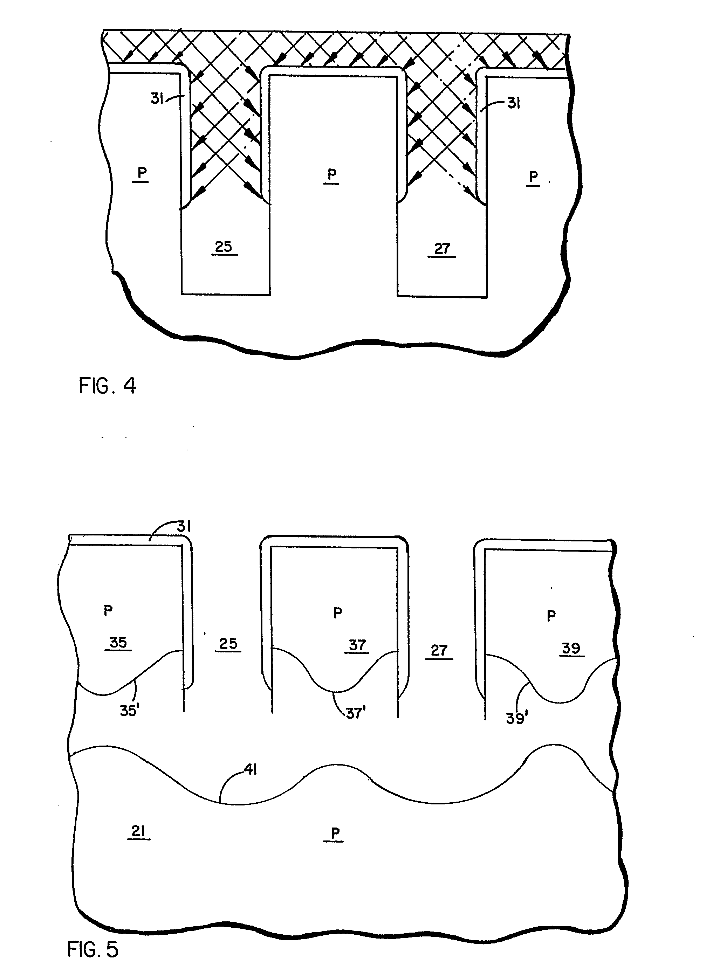

In FIG. 4 it may be appreciated why the slots 25 and 27 are necessary. They permit angle evaporation of etch-resist 31 to the edges of the slots 25 and 27. The result provides a protective covering over the tops of the active regions being formed. Also, it should be noted that due to the angle of evaporation of the etch resist 31, this protective layer only extends to a certain depth within slots 25 and 27, but this depth must be adequate to protect the active regions being formed. Thus, in FIG. 5, it may be seen that the active regions are generally shown at 35, 37 and 39 above the silicon substrate etch level 41 and also above the etch levels 35', 37' and 39' where the etch introduced through the slots 25 and 27 removed the substrate from beneath the active regions 35, 37 and 39.

Actually, there are a plurality of active regions aligned in the remaining portions 35, 37 and 39 which represent semi-arrays of transistors being formed. Obviously, the semi-arrays are supported at their ends or spaced apart positions so that the active regions do not collapse into the substrate etched space 41.

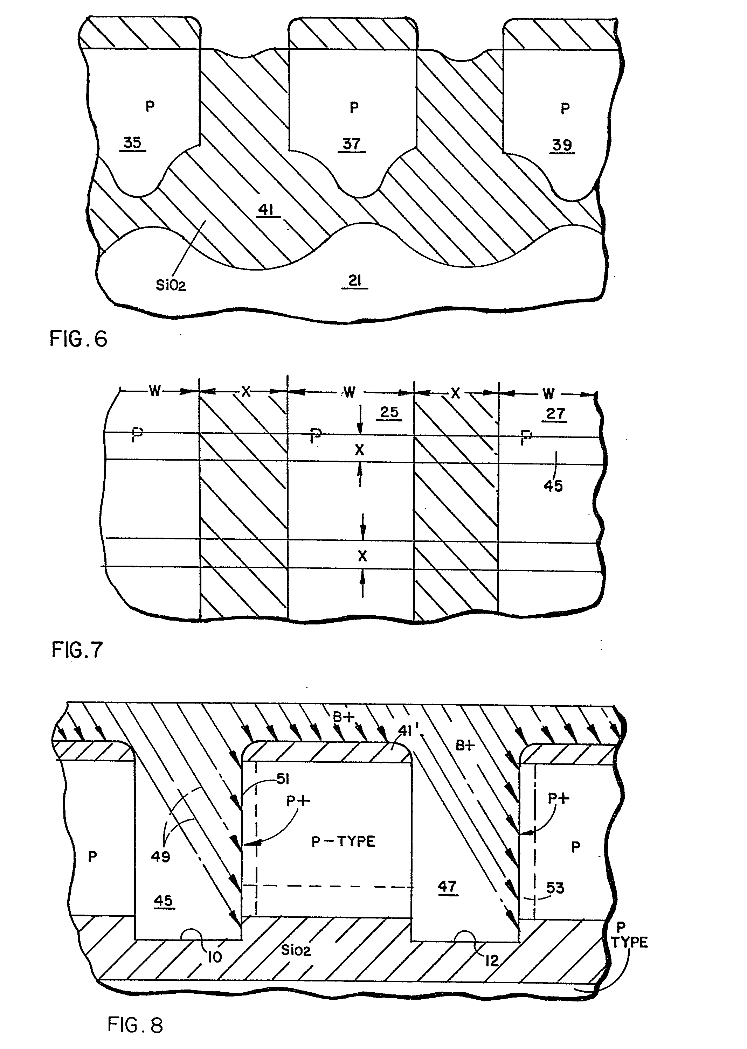

In FIG. 6 it may be seen that the etch resist 31 has been removed and the silicon has been oxidized to $SiO_2$ shown at 41 as filling all the voids between regions 35, 37 and 39 and the silicon substrate 21. Thus, with the regions supported now by the silicon oxide 41, the orthogonally related sets of slots 45 and 47 may be formed as illustrated in the top plan view of FIG. 7. The procedure for forming these slots is the same as before, requiring a photoresist layer patterned in the form of spaced apart slots and the silicon material either ion milled away or etched using O.D.E. techniques, as best shown in FIG. 8.

In FIG. 8 the application of P+ doping is achieved by boron implant shown by the arrows 49 to produce the P+ region 51. It should be noted that this implanting is done only into the corresponding right hand edges of slots 45 and 47 to provide the P+ layers 51 and 53.

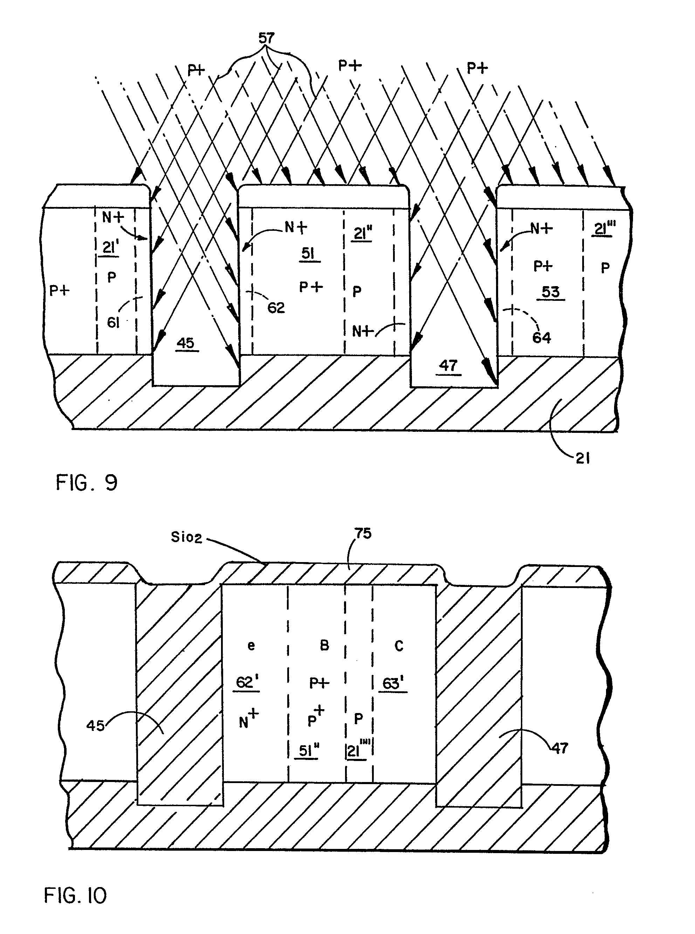

In FIG. 9 it may be seen that the P+ regions have been driven in, such as by using high heat so that they are expanded as shown by 51' and 53'. Also, a further P+ region is visible to the left at 55', having been produced by a slot to the left of the margin of the page.

Next in FIG. 9 it will be seen that phosphorus is implanted (or deposited) into both edges of each slot as shown by the arrows 57 to provide the N+ regions 61, 62, 63 and 64. It may also be pointed out that the P regions 21', 21'' and 21''' are the remaining regions from the original P type silicon substrate.

Proceeding from FIG. 9 to FIG. 10, it may be seen that the phosphorus N+ regions 62 and 63 have now been driven in to comprise the expanded regions 62' and 63'. Accordingly the P+ region has been changed in size and is now designated 51'' as is also true of the remaining P region now identified as 21'''''. The region 62' will comprise the emitter with the regions 51'' and 21''''' comprising a graded base region and finally region 63' being the collector region.

Also, in FIG. 10 it may be seen that the substrate has again been oxidized to fill in the slots 45 and 47 and provide a covering over the active region of the electrodes generally shown at 75. The doping gradient in the base region is similar to convention double diffused transistors.

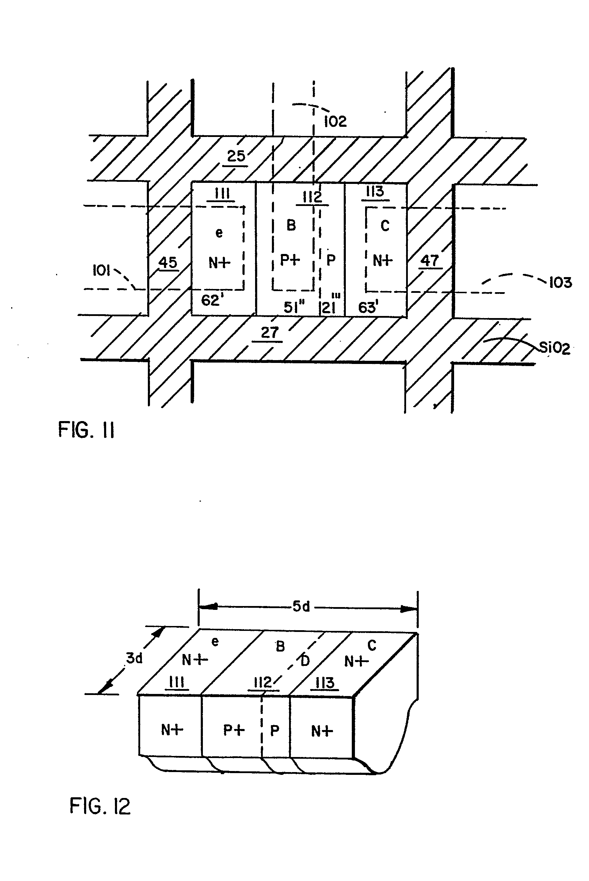

A finished transistor shown in FIG. 11 wherein the contacts 101, 102 and 103 are provided from a metallization layer for the emitter 111, base 112 and collector 113 respectively. These contacts are fabricated simply by conventional techniques for patterning or metallization.

It may be seen that the transistor comprising these three electrodes is surrounded by moats of silicon oxide formed in the slots 25,27 and 45,47. Thus, the transistor is isolated from adjacent transistors or other elements.

The active region of the transistor is visible in FIG. 12 and perspective showing the emitter 111 base 112 and collector 113.

While modifications may readily appear to those skilled in the art, it is intended that the scope of the invention be defined in the appended claims, wherein:

What is Claimed is:

1. An array of sub-micron dimensioned NPN type lateral transistors formed on a substrate doped P-type, each comprising in combination:

spaced apart slots in the substrate through selected ones of which P+ type doping is received into the adjacent substrate and driven in followed by N+ doping driven in through opposed slots;

said slots filled with field oxide and surrounding each region where a transistor will be formed;

said N+ doping on the inner sides of spaced apart slots within said regions comprising emitter and collector electrode areas;

said P+ doping and the P substrate in said region between the N+ regions comprising base electrode areas; and,

metallization connections to each N+ and P+ P electrode area.

2. The transistor of Claim 1, wherein:

said region is substantially rectangular having a length of 5d and a width of 3d wherein d is 0.4 to 1 micrometer.

3. The transistor of Claim 1 wherein said region is isolated by substrate oxidation from the substrate.

4. A sub-micron dimensioned NPN type lateral transistor formed in a P-type substrate, comprising in combination:

a transistor region isolated from the substrate by substrate oxide filling orthogonally related slots around the region and completely underlying the region;

said region comprising an emitter N+ electrode, a base P+ and P electrode, and a collector N+ electrode;

said region doped from a first side through a first slot prior to filling said slot with oxide by P+ doping driven in followed by N+ doping driven in; and,

said region doped from a side opposite said first side by N+ doping driven in.

5. The transistor of Claim 4, wherein:

the P+ doping is supplied by positive boron ions angle implanted relative to said first side and the N+ doping is supplied by phosphorus angle implanted through said first side and said opposite side.

6. A method for forming an array of sub-micron dimensioned NPN-type lateral transistors on a substrate doped P-type, wherein each transistor is formed comprising the following steps:

masking the substrate to outline a pair of boundary regions for each semi-array of active regions to comprise a transistor;

slotting the substrate in said boundary regions to a given depth;

angle evaporating etch resist to cover the active regions of the substrate and the edges of said slots to a given depth via the slotted boundary regions;

etching away the substrate below said depth sufficiently to separate the semi-arrays of active regions from the substrate except at spaced apart locations therealong;

oxidizing the substrate to fill in the portions etched away and the slots;

slotting the substrate orthogonally to the first mentioned slots to provide second slots with orthogonal pairs of slots defining active regions for the respective transistors;

doping the regions defined by orthogonal pairs of slots P+ via corresponding edges of the second slots and driving in the P+ doping;

doping of said last mentioned regions via both edges of each slot N+ and driving in the N+ doping;

oxidizing the substrate to completely isolate said active regions from the substrate; and,

establishing electrical connections to the outer N+ regions and inner P+P region.

7.  The method of Claim 6, wherein:

said slots are formed by one of ion milling and orientation dependent etching.

8.  The method of Claims 6 and 7 wherein:

the etching away of the substrate underlying said semi-arrays is accomplished by using an isotropic etch.

9.  The method of Claims 6, 7 and 8, wherein:

the P+ doping is effected by angle implanting boron.

10.  The method of Claims 6, 7, 8 and 9 wherein:

the N+ doping is effected by angle implanting phosphorus.

FIG. I

FIG. 2

FIG. 3

FIG. 4

FIG. 5

FIG.6

FIG.7

FIG.8

FIG. 9

FIG. 10

0059264

FIG. 11

FIG. 12

# EUROPEAN SEARCH REPORT

Application number

EP 81 11 0369.6

| | DOCUMENTS CONSIDERED TO BE RELEVANT | | CLASSIFICATION OF THE APPLICATION (Int. Cl. 3) |
|---|---|---|---|
| Category | Citation of document with indication, where appropriate, of relevant passages | Relevant to claim | |
| A | <u>US - A - 4 104 090</u> (H.B. POGGE)<br>* claim 1; fig. 1 to 5 * | 1,3,4<br>6 | H 01 L 21/76<br>H 01 L 21/308<br>H 01 L 29/06 |
| A | <u>EP - A1 - 0 004 298</u> (WESTERN ELECTRIC CO.)<br>* page 5, line 11 to page 8, line 1 * | 1,6,7 | |
| A | Patent Abstracts of Japan,<br>Vol. 4, No. 152, 24 October 1980<br>page 151E31<br>& JP - A - 55 - 105324 | 5,9,10 | **TECHNICAL FIELDS SEARCHED (Int.Cl. 3)** |
| A,P | <u>EP - A1 - 0 038 248</u> (THOMSON-CSF)<br>* page 9, line 19 to page 10, line 25 * | 6 | H 01 L 21/306<br>H 01 L 21/312<br>H 01 L 21/76<br>H 01 L 27/08<br>H 01 L 27/10<br>H 01 L 29/06<br>H 01 L 29/72 |

**CATEGORY OF CITED DOCUMENTS**

X: particularly relevant if taken alone
Y: particularly relevant if combined with another document of the same category
A: technological background
O: non-written disclosure
P: intermediate document
T: theory or principle underlying the invention
E: earlier patent document, but published on, or after the filing date
D: document cited in the application
L: document cited for other reasons

&: member of the same patent family, corresponding document

The present search report has been drawn up for all claims

| Place of search | Date of completion of the search | Examiner |
|---|---|---|
| Berlin | 27-05-1982 | GIBBS |

EPO Form 1503.1 06.78